# EUROPEAN PATENT APPLICATION

(11) **EP 4 826 720 A1**
(43) Date of publication of application: **21.10.2026**
(21) Application number: 26171542.9
(22) Date of filing: 09.04.2026
(51) Int. Cl.: G11C 5/02, G11C 5/04

(54) **HIGH BANDWIDTH MEMORY HAVING ROTATED DYNAMIC RANDOM ACCESS MEMORY STACK ON LOGIC DIE AND RELATED SEMICONDUCTOR PACKAGE**

(30) Priority: 11.04.2025 US 202563787268 P; 08.04.2026 US 202619641542
(71) Applicant: MediaTek Inc., Hsinchu City 30078 (TW)
(72) Inventor: KUMAR, Arvind, San Jose, CA 95134 (US); KOLLURU, Krishna Bharath, San Jose, CA 95134 (US); NALAMALPU, Ankireddy, San Jose, CA 95134 (US); GADEY, Siva, San Jose, CA 95134 (US); SUBBAREDDY, Dheeraj Reddy, San Jose, CA 95134 (US); KUMASHIKAR, Mahesh K., San Jose, CA 95134 (US); CHEN, Tai-Yu, 30078 Hsinchu City (TW); HUANG, Wun-Chien, 30078 Hsinchu City (TW); LIN, Chun-Yin, 30078 Hsinchu City (TW)
(74) Representative: Pfenning, Meinig & Partner mbB

(57) **Abstract**

A high bandwidth memory, HBM, (104) includes a logic die (108) and a dynamic random access memory, DRAM, stack (111). The DRAM stack (111) includes a plurality of HBM DRAM dies (110) and a plurality of through-silicon via, TSV, stacks (112). The HBM DRAM dies (110) are vertically stacked on the logic die (108). The TSV stacks (112) are configured to electrically connect the HBM DRAM dies (110) to the logic die (108) through a plurality of bumps (118) formed on a TSV bump area (204) defined on the logic die (108), where the TSV bump area (204) is along a horizontal direction specified by a layout orientation of the logic die (108).

## Description

### Field of the Invention

The present disclosure relates to an integrated circuit (IC) design, and more particularly, to a high bandwidth memory (HBM) having a rotated dynamic random access memory (DRAM) stack on a logic die and a related semiconductor package.

### Background of the Invention

HBM systems are commonly utilized in application-specific integrated circuit (ASIC) chip designs that utilize special purposes processors such as artificial intelligence (Al) accelerators, graphics processing units (GPUs), central processing units (CPUs), or other datacenter processors. An HBM adopts a three-dimensional (3D) stacking approach by vertically stacking multiple HBM DRAM dies on a logic die (also called base die), and uses through-silicon via (TSV) stacks to electrically connect the HBM DRAM dies to the logic die. In a conventional HBM design, the TSV stacks are formed in central positions of the DRAM stack and require a vertical TSV bump area on the logic die. This makes the implementation challenging due to the fact that TSV stacks are metallic pillars. Since each TSV requires a keep out zone (KOZ), signal routing from one side of the vertical TSV bump area is blocked from passing through the TSV bump area to reach the other side of the TSV bump area.

### Summary of the Invention

This in mind, the present invention aims at providing an HBM (e.g., custom HBM) having a rotated DRAM stack on a logic die (e.g., custom logic die) and a related semiconductor package.

This is achieved by an HBM and a semiconductor package according to the independent claims. The dependent claims pertain to corresponding further developments and improvements. The scope of the invention is defined by the appended sets of claims.

As will be seen more clearly from the detailed description following below, the claimed HBM includes a logic die and a DRAM stack. The DRAM stack includes a plurality of HBM DRAM dies and a plurality of TSV stacks. The HBM DRAM dies are vertically stacked on the logic die. The TSV stacks are configured to electrically connect the HBM DRAM dies to the logic die through a plurality of bumps formed on a TSV bump area defined on the logic die, wherein the TSV bump area is along a horizontal direction specified by a layout orientation of the logic die.

The claimed semiconductor package includes a compute die and an HBM. The HBM includes a logic die and a DRAM stack. The DRAM stack includes a plurality of HBM DRAM dies and a plurality of TSV stacks. The HBM DRAM dies are vertically stacked on the logic die. The TSV stacks are configured to electrically connect the HBM DRAM dies to the logic die through a plurality of bumps formed on a TSV bump area defined on the logic die. The TSV bump area is along a direction perpendicular to a first side of the logic die that is adjacent to the compute die.

### Brief Description of the Drawings

In the following, the invention is further illustrated by way of example, taking reference to the accompanying drawings. Thereof
FIG. 1 is a diagram illustrating a structure of a semiconductor package according to an embodiment of the present invention,
FIG. 2 is a diagram illustrating a vertical TSV bump area on the conventional logic die and a horizontal TSV bump area on the proposed logic die,
FIG. 3 is a top view of the logic die shown in FIG. 1, and
FIG. 4 is a diagram illustrating a design of signal routing on the top side and the bottom side of the TSV bump area according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

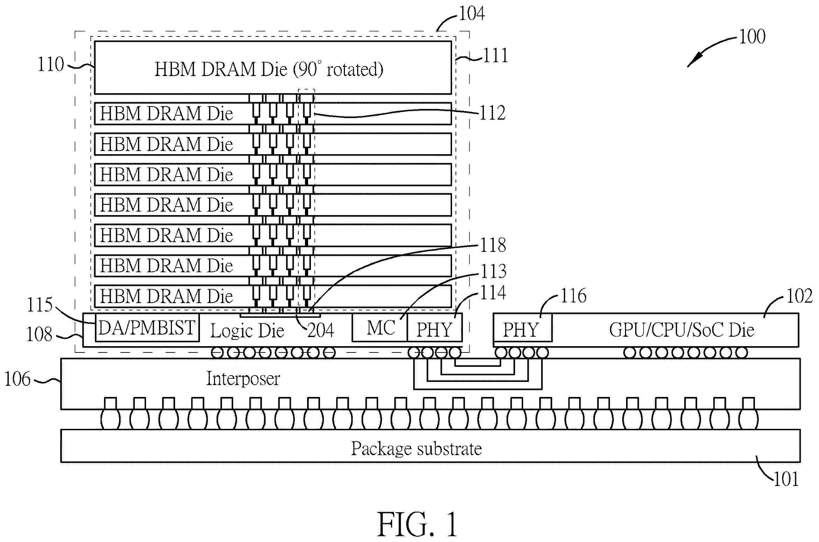

FIG. 1 is a diagram illustrating a structure of a semiconductor package according to an embodiment of the present invention. The semiconductor package 100 may be an ASIC chip. As shown in FIG. 1, the semiconductor package 100 includes a package substrate 101, a compute die 102, an HBM 104, and an interposer 106. Both of the compute die 102 and the HBM 104 are mounted on the interposer 105, and are connected through the interposer 105. In this embodiment, the compute die 102 and the HBM 104 are placed side-by-side on the interposer 105. The HBM 104 adopts a three-dimensional (3D) stacking approach by vertically stacking multiple HBM DRAM dies 110 on a logic die (also called base die) 108. Specifically, the HBM 104 has a DRAM stack 111 (which includes vertically stacked HBM DRAM dies 110) on the logic die 108. The DRAM stack 111 further includes multiple TSV stacks 112 each having TSVs formed within all HBM DRAM dies 110 except the top HBM DRAM die. The TSV stacks 112 are configured to electrically connect the HBM DRAM dies 110 to the logic die 108. The logic die 108 is a fundamental, non-memory layer at the bottom of the 3D memory stack, and provides an interface with the compute die (e.g., GPU/CPU/SoC die) 102. For example, the logic die 108 has a physical layer (PHY) circuit (labeled by "PHY") 114 that is electrically connected to a PHY circuit (labeled by "PHY") 116 on the compute die 102. The PHY circuit 114/116 includes a plurality of physical channels each split into multiple pseudo channels. For example, regarding one 3D memory stack of the HBM 104, one 64-bit physical channel may be split into two 32-bit pseudo channels.

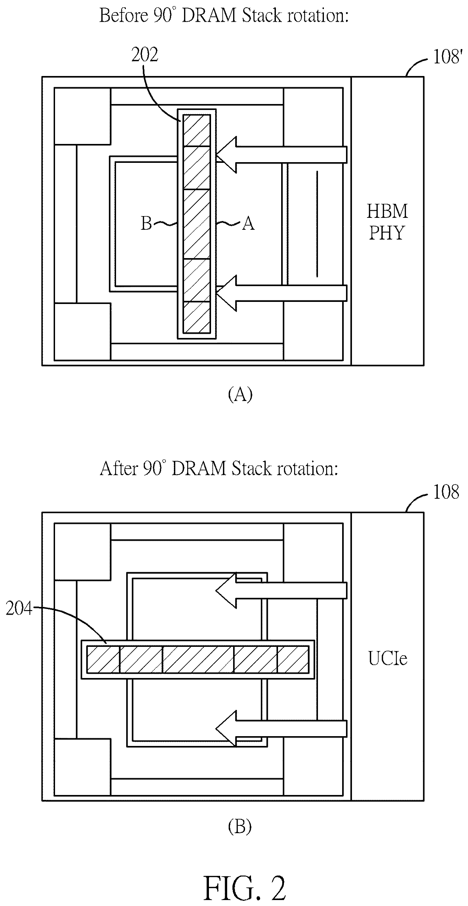

If the DRAM stack 111 manufactured and provided by a DRAM vendor is not rotated by 90 degrees before being mounted on a conventional logic die 108' through a plurality of bumps (e.g., micro bumps), a vertical TSV bump area 202 is defined on the conventional logic die 108', as illustrated in sub-diagram (A) of FIG. 2. Since the vertical TSV bump area 202 is along a vertical direction specified by a layout orientation of the conventional logic die 108' and KOZ requirements for TSVs should be met, signal routing from one side A of the vertical TSV bump area 202 is blocked from passing through the vertical TSV bump area 202 to reach the other side B of the vertical TSV bump area 202. Such a vertical TSV bump area makes it difficult to add extra logic circuits (i.e., more logic functions) to a logic die (base die) for realizing a custom logic die of a custom HBM (also called cHBM).

In this embodiment, the DRAM stack 111 manufactured and provided by a DRAM vendor is rotated by 90 degrees before being mounted on the logic die 108 through a plurality of bumps 118 (e.g., micro bumps), where each of the bumps 118 is connected to one of the TSV stacks 112. With the aid of 90-degree DRAM stack rotation with respect to the logic die, locations of the TSV stacks 112 change, allowing a horizontal TSV bump area 204 to be defined on the logic die 108, as illustrated in sub-diagram (B) of FIG. 2. The bumps 118 are formed on the horizontal TSV bump area 204 that is along a horizontal direction specified by a layout orientation of the defined on the logic die 108. Rotating the DRAM stack 111 by 90 degrees has no routing issues. Such a horizontal TSV bump area makes it easy to add extra logic circuits (i.e., more logic functions) to a logic die for realizing a custom logic die of a custom HBM. For example, in addition to fundamental functions of a typical logic die, the logic die 108 of the HBM 104 (i.e., custom logic die of cHBM) may include additional logic functions, including direct access (DA), programmable memory built-in-self-test (PMBIST), memory controller (MC), etc. Regarding the embodiment shown in FIG. 1, the logic die 108 may include two logic circuits 113 and 115, where the logic circuit (labeled by "MC") 113 is configured to deal with an MC function, and the logic circuit (labeled by "DA/PMBIST") 115 is configured to deal with a DA/PMBIST function. A system-technology co-optimization (STCO) approach can be used to assemble multiple asynchronously designed dies into the single semiconductor package 100. For example, the shoreline would become 14mm from 11mm.

It should be noted that the package structure shown in FIG. 1 is for illustrative purposes only, and is not meant to be a limitation of the present invention. In practice, the present invention has no limitations on the packaging technology used for assembling and encapsulating the compute die 102 and the HBM 104. Furthermore, the number of compute dies and the number of HBMs may be adjusted depending upon actual application considerations. In some embodiments of the present invention, the semiconductor package 100 may be an ASIC chip having more than one compute die 102 and/or more than one HBM 104. To put it simply, any semiconductor package having a 90-degree rotated DRAM stack mounted on a logic die (base die) with a horizontal TSV bump area falls within the scope of the present invention.

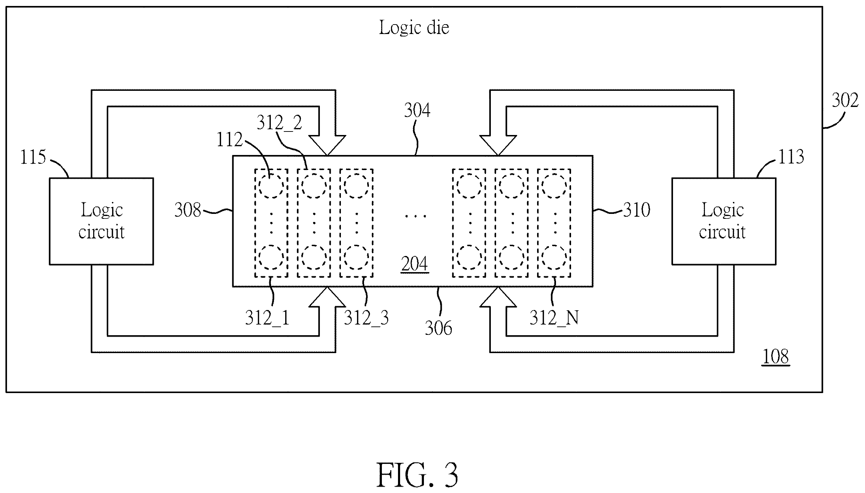

FIG. 3 is a top view of the logic die 108 shown in FIG. 1. The TSV bump area 204 is along a horizontal direction specified by a layout orientation of the logic die 108. Since the HBM 104 and the compute die 102 are placed side-by-side on the interposer 106, the logic die 108 has one side 302 (e.g., right side or east side) that is adjacent to the compute die 102. The TSV bump area 204 is a rectangular area. As shown in FIG, 3, the TSV bump area 204 has a top side 304 and a bottom side 306 both perpendicular to the logic die's side 302 adjacent to the compute die 102, and has a left side 308 and a right side 306 both parallel with the logic die's side 302 adjacent to the compute die 102. The TSV bump area 204 is alone a direction perpendicular to the logic die's side 302 that is adjacent to the compute die 102. In this embodiment, each of the logic circuits 113 and 115 is electrically connected to the TSV stacks 112 through bumps (e.g., micro bumps) formed on the TSV bump area 204. The logic circuit 115 (e.g., DA/PMBIST circuit) is placed on the left side of the TSV bump area 204. The logic circuit 113 (e.g., MC circuit) is placed on the right side of the TSV bump area 204.

Since the TSV bump area 204 is a horizontal TSV bump area, signal traces of the logic circuit 113 can be routed to the top side and the bottom side of the TSV bump area 204, and signal traces of the logic circuit 115 can be routed to the top side and the bottom side of the TSV bump area 204. In this embodiment, the TSV stacks 112 are categorized into a plurality of TSV stack groups 312_1-302_N (N > 1) corresponding to different channels of the HBM 104, respectively. For example, the TSV stack group 312_1 corresponds to channel CH0, the TSV stack group 312_2 corresponds to channel CH1, the TSV stack group 312_3 corresponds to channel CH2, and so on. In some embodiments of the present invention, the logic circuits 113 and 115 are electrically connected to TSV stack groups 312_1-312_N from the top side of the TSV bump area 204 in an interleaving fashion, and the logic circuits 113 and 115 are electrically connected to TSV stack groups 312_1-312_N from the bottom side of the TSV bump area 204 in an interleaving fashion. For example, the logic circuit 115 is electrically connected to a first channel of the HBM 104 from the top side of the TSV bump area 204, and the logic circuit 113 is electrically connected to the first channel of the HBM 104 from the bottom side of the TSV bump area; and the logic circuit 115 is electrically connected to a second channel of the HBM 104 from the bottom side of the TSV bump area 204, and the logic circuit 113 is electrically connected to the second channel of the HBM 104 from the top side of the TSV bump area 204. The first channel and the second channel may be adjacent channels of the HBM 104.

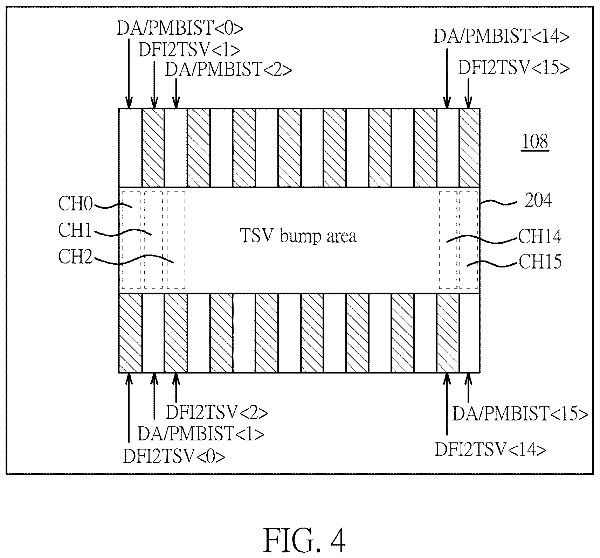

FIG. 4 is a diagram illustrating a design of signal routing on the top side and the bottom side of the TSV bump area 204 (which is a horizontal TSV bump area) according to an embodiment of the present invention. Suppose that the logic circuit 115 is a memory test circuit (e.g., DA/PMBIST circuit), the logic circuit 113 is a memory controller circuit, and the TSV stacks 112 are categorized into 16 TSV stack groups 312_1-302_N (N = 16) corresponding to 16 channels CH0-CH15 of the HBM 104, respectively. As shown in FIG. 4, test signal traces DA/PMBIST<0>, DA/PMBIST<2>, ..., DA/PMBIST<14> and memory access signal traces DFI2TSV<1>, ..., DFI2TSV<15> are arranged on the top side of the TSV bump area 204 in an alternating fashion, and memory access signal traces DFI2TSV<0>, DFI2TSV<2>, ..., DFI2TSV<14> and test signal traces DA/PMBIST<1>, ..., DA/PMBIST<15> are arranged on the bottom side of the TSV bump area 204 in an alternating fashion. Hence, the memory test circuit can perform test to the HBM channel CH0 through the test signal trace DA/PMBIST<0> from the top side of the TSV bump area 204, and the memory controller circuit can perform access (read/write) to the HBM channel CH0 through the memory access signal trace DFI2TSV<0> from the bottom side of the TSV bump area 204; the memory test circuit can perform test to the HBM channel CH1 through the test signal trace DA/PMBIST<1> from the bottom side of the TSV bump area 204, and the memory controller circuit can perform access (read/write) to the HBM channel CH1 through the memory access signal trace DFI2TSV<1> from the top side of the TSV bump area 204; the memory test circuit can perform test to the HBM channel CH2 through the test signal trace DA/PMBIST<2> from the top side of the TSV bump area 204, and the memory controller circuit can perform access (read/write) to the HBM channel CH2 through the memory access signal trace DFI2TSV<2> from the bottom side of the TSV bump area 204; the memory test circuit can perform test to the HBM channel CH14 through the test signal trace DA/PMBIST<14> from the top side of the TSV bump area 204, and the memory controller circuit can perform access (read/write) to the HBM channel CH14 through the memory access signal trace DFI2TSV<14> from the bottom side of the TSV bump area 204; and the memory test circuit can perform test to the HBM channel CH15 through the test signal trace DA/PMBIST<15> from the bottom side of the TSV bump area 204, and the memory controller circuit can perform access (read/write) to the HBM channel CH15 through the memory access signal trace DFI2TSV<15> from the bottom side of the TSV bump area 204.

## Claims

1. A high bandwidth memory, HBM, (104) **characterized by**:
a logic die (108); and
a dynamic random access memory, DRAM, stack (111), comprising:
a plurality of HBM DRAM dies (110), vertically stacked on the logic die (108); and
a plurality of through-silicon via, TSV, stacks (112), configured to electrically connect the plurality of HBM DRAM dies (110) to the logic die (108) through a plurality of bumps (118) formed on a TSV bump area (204) defined on the logic die (108), wherein the TSV bump area (204) is along a horizontal direction specified by a layout orientation of the logic die (108).

2. The HBM (104) of claim 1, **characterized in that** the logic die (108) comprises a first logic circuit (115) and a second logic circuit (113), each of the first logic circuit (115) and the second logic circuit (113) is electrically connected to the plurality of TSV stacks (112), the first logic circuit (115) is on a left side of the TSV bump area (204), and the second logic circuit (113) is on a right side of the TSV bump area (204).

3. The HBM (104) of claim 2, **characterized in that** one of the first logic circuit (115) and the second logic circuit (113) is a memory controller circuit.

4. The HBM (104) of claim 2, **characterized in that** one of the first logic circuit (115) and the second logic circuit (113) is a memory test circuit.

5. The HBM (104) of claim 2, **characterized in that** the plurality of TSV stacks (112) are categorized into a plurality of TSV stack groups (312_1, 312_2, 312_3, 312_N) corresponding to a plurality of channels (CH0, CH1, CH2, CH14, CH15) of the HBM (104), respectively; the first logic circuit (115) is electrically connected to a first channel of the HBM (104) from a top side of the TSV bump area (204), and the second logic circuit (113) is electrically connected to the first channel of the HBM (104) from a bottom side of the TSV bump area (204); and the first logic circuit (115) is electrically connected to a second channel of the HBM (104) from the bottom side of the TSV bump area (204), and the second logic circuit (113) is electrically connected to the second channel of the HBM (104) from the top side of the TSV bump area (204).

6. The HBM (104) of claim 5, **characterized in that** the first channel and the second channel are adjacent channels of the HBM (104).

7. The HBM (104) of claim 1, **characterized in that** the HBM (104) is a custom HBM, cHBM, with the logic die (108) being a custom logic die.

8. A semiconductor package (100) **characterized by**:
a compute die; and
a high bandwidth memory, HBM, (104) comprising:
a logic die (108); and
a dynamic random access memory, DRAM, stack (111), comprising:
a plurality of HBM DRAM dies (110), vertically stacked on the logic die (108); and
a plurality of through-silicon via, TSV, stacks (112), configured to electrically connect the plurality of HBM DRAM dies (110) to the logic die (108) through a plurality of bumps (118) formed on a TSV bump area (204) defined on the logic die (108);
wherein the TSV bump area (204) is along a direction perpendicular to a first side of the logic die (108) that is adjacent to the compute die (102).

9. The semiconductor package (100) of claim 8, **characterized in that** the logic die (108) comprises a first logic circuit (115) and a second logic circuit (113), each of the first logic circuit (115) and the second logic circuit (113) is electrically connected to the plurality of TSV stacks (112), the first logic circuit (115) is on a first side of the TSV bump area (204), the second logic circuit (113) is on a second side of the TSV bump area (204), and each of the first side and the second side is parallel with the first side of the logic die (108).

10. The semiconductor package (100) of claim 9, **characterized in that** one of the first logic circuit (115) and the second logic circuit (113) is a memory controller circuit.

11. The semiconductor package (100) of claim 9, **characterized in that** one of the first logic circuit (115) and the second logic circuit (113) is a memory test circuit.

12. The semiconductor package (100) of claim 9, **characterized in that** the plurality of TSV stacks (112) are categorized into a plurality of TSV stack groups (312_1, 312_2, 312_3, 312_N) corresponding to a plurality of channels (CH0, CH1, CH2, CH14, CH15) of the HBM (104), respectively; the first logic circuit (115) is electrically connected to a first channel of the HBM (104) from a third side of the TSV bump area (204), and the second logic circuit (113) is electrically connected to the first channel of the HBM (104) from a fourth side of the TSV bump area (204); and the first logic circuit (115) is electrically connected to a second channel of the HBM (104) from the fourth side of the TSV bump area (204), the second logic circuit (113) is electrically connected to the second channel of the HBM (104) from the third side of the TSV bump area (204), and each of the third side and the fourth side is perpendicular to the first side of the logic die (108).

13. The semiconductor package (100) of claim 12, **characterized in that** the first channel and the second channel are adjacent channels of the HBM (104).

14. The semiconductor package (100) of claim 8, **characterized in that** the HBM (104) is a custom HBM, cHBM, with the logic die (108) being a custom logic die.
